# EUROPEAN PATENT SPECIFICATION

(11) **EP 1 814 375 B1**
(45) Date of publication and mention of the grant of the patent: **16.06.2010**
(21) Application number: 07002062.3
(22) Date of filing: 31.01.2007
(51) Int. Cl.: H05K 13/04, H05K 13/08

(54) **Electronic component mounting apparatus**
Vorrichtung zur Montage von elektronischen Bauteilen
Appareil de montage de composant électronique

(30) Priority: 31.01.2006 JP 2006345114
(43) Date of publication of application: 01.08.2007
(73) Proprietor: Hitachi High-Tech Instruments Co., Ltd., Ora-gun, Gunma-ken, 370-0596 (JP)
(72) Inventor: Ieizumi, Kazuyoshi, Ota-shi, Gunma 373-0813 (JP); Aoki, Akira, Ota-shi, Gunma 373-0026 (JP); Kameda, Makio, Ota-shi, Gunma 373-0808 (JP); Fukushima, Yoshiharu, Ora-Gun, Gunma 370-0514 (JP); Kashitani, Hisayoshi, Ota-shi, Gunma 373-08060 (JP)
(74) Representative: Glawe, Delfs, Moll

(56) References cited:
- EP-A- 1 081 998
- US-A- 6 044 169

## Description

### BACKGROUND OF THE INVENTION

### Field of the Invention

The invention relates to an electronic component mounting apparatus having a component feeding unit supplying an electronic component to a component pickup position, a mounting head rotatable around a vertical axis by operation of a rotation mechanism and a vertically movable suction nozzle provided on the mounting head in an eccentric position thereof, picking up the electronic component from the component feeding unit and mounting the electronic component on a printed board.

### Description of the Related Art

This kind of electronic component mounting apparatus has been known well as described, for example, in Japanese Patent Application Publication No. 2001-156498. When an electronic component supplied from the component feeding unit is to be picked up by suction by the suction nozzle or when the picked electronic component is to be mounted on a printed board, the suction nozzle is lowered by operating a vertical movement mechanism, picks up the electronic component at a pickup position or mounts the electronic component on the board, is moved upward, and is moved in the horizontal direction to above the printed board or to above the component feeding unit.

There is a case where the rotation movement to the vertical movement mechanism and the vertical movement of the suction nozzle are performed simultaneously when the electronic component is to be picked up from the component feeding unit or to be mounted on the printed board in order to reduce mounting time taken to move the suction nozzle to the vertical movement mechanism, lower the suction nozzle, complete the pickup operation and the mounting operation of the electronic component, and move the suction nozzle upward, that is, so-called takt time. When the rotation movement and the vertical movement of the suction nozzle are to be performed simultaneously for picking up the electronic component from the component feeding unit or for mounting the electronic component on the printed board, timing to start the lowering of the suction nozzle during its rotation when the electronic component is to be picked up or mounted is controlled so as to avoid the contact of the lower surface of the suction nozzle or the electronic component held by the suction nozzle and the component feeding unit, an electronic component already mounted on the printed board or a structure component of the electronic component mounting apparatus.

However, start delay of the vertical movement motor of the suction nozzle delays the timing to start the lowering of the suction nozzle during its rotation when the electronic component is to be picked up or mounted. Furthermore, since the timing is not changed even when the vertical movement speed of the suction nozzle is increased depending on the types of the electronic components, there is a problem that takt time is still long.

It is thus an object of the invention to provide an improved mounting apparatus that lessens this drawback.

### SUMMARY OF THE INVENTION

The solution according to the invention resides in the features of the independent claims and preferably in those of the dependent claims.

The invention provides an electronic component mounting apparatus having a component feeding unit supplying an electronic component, a suction nozzle picking up the electronic component supplied by the component feeding unit by suction, a mounting head mounted with the suction nozzle, a rotation mechanism rotating the mounting head around a vertical axis and a vertical movement table vertically moving the suction nozzle by operation of a vertical movement mechanism, and mounting the electronic component picked up by suction by the suction nozzle on a printed board by vertically moving the suction nozzle, the electronic component mounting apparatus comprising: a control device calculating lowering time taken to lower the suction nozzle to height where a lower surface of the electronic component held by suction by the suction nozzle does not contact other electronic component mounted on the printed board, calculating moving time taken to move the suction nozzle by rotation from an edge of the vertical movement table to a target position on the vertical movement table, calculating base time by adding start delay time of the vertical movement mechanism to shorter one of the lowering time and the moving time, calculating a moving distance of movement of the suction nozzle by rotation during the base time, determining a position returned from the target position on the vertical movement table by the moving distance as a start position for the vertical movement mechanism, and starting the vertical movement mechanism when the control device recognizes that the suction nozzle passes the start position by rotation.

The invention also provides an electronic component mounting apparatus having a component feeding unit supplying an electronic component, a suction nozzle picking up the electronic component supplied by the component feeding unit by suction, a mounting head mounted with the suction nozzle, a rotation mechanism rotating the mounting head around a vertical axis and a vertical movement table vertically moving the mounting head by operation of a vertical movement mechanism, and mounting the electronic component picked up by suction by the suction nozzle on a printed board by vertically moving the suction nozzle, the electronic component mounting apparatus comprising: a control device calculating lowering time taken to lower the suction nozzle to height where the suction nozzle does not contact the component feeding unit, calculating moving time taken to move the suction nozzle by rotation from an edge of the vertical movement table to a target position on the vertical movement table, calculating base time by adding start delay time of the vertical movement mechanism to shorter one of the lowering time and the moving time, calculating a moving distance of movement of the suction nozzle by the rotation mechanism during the base time, determining a position returned from the target position on the vertical movement table by the moving distance as a start position for the vertical movement mechanism, and starting the vertical movement mechanism when the control device recognizes that the suction nozzle passes the start position by rotation.

The invention minimizes the mounting time of each of the electronic components by starting the simultaneous operation of the vertical movement and the rotation of the suction nozzle as early as possible by controlling the timing to start the lowering of the suction nozzle based on the start delay and the vertical movement speed of the vertical movement mechanism of the suction nozzle.

### BRIEF DESCRIPTION OF THE DRAWINGS

Fig. 1 is a plan view of an electronic component mounting apparatus.
Fig. 2 is a front view of the electronic component mounting apparatus.
Fig. 3 is a right side view of the electronic component mounting apparatus.
Fig. 4 is a control block diagram of the electronic component mounting apparatus.
Fig. 5 is a longitudinal cross-sectional view of a front of a mounting head body.
Fig. 6 is a longitudinal cross-sectional view of a side of the mounting head body.
Fig. 7 is a plan view of a fixing support piece and a vertical movement table.
Fig. 8 is a schematic bottom view of the mounting head.

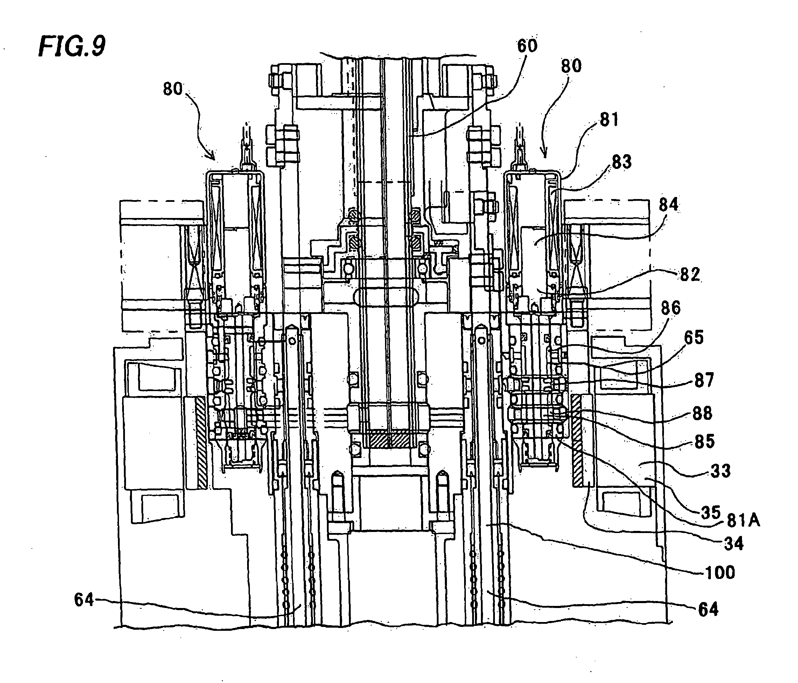

Fig. 9 is an enlarged longitudinal cross-sectional view of a lower portion of a front of the mounting head.
Fig. 10 is a view showing an operation screen displayed on a monitor.
Fig. 11 is a flow chart.
Fig. 12 is a table showing mounting data.
Fig. 13 is a table showing component disposition data.
Fig. 14 is a table showing component library data where component ID is C0402.
Fig. 15 is a table showing component library data where component ID is C0603.
Fig. 16 is a table showing component library data where component ID is R0603.

### DETAILED DESCRIPTION OF THE INVENTION

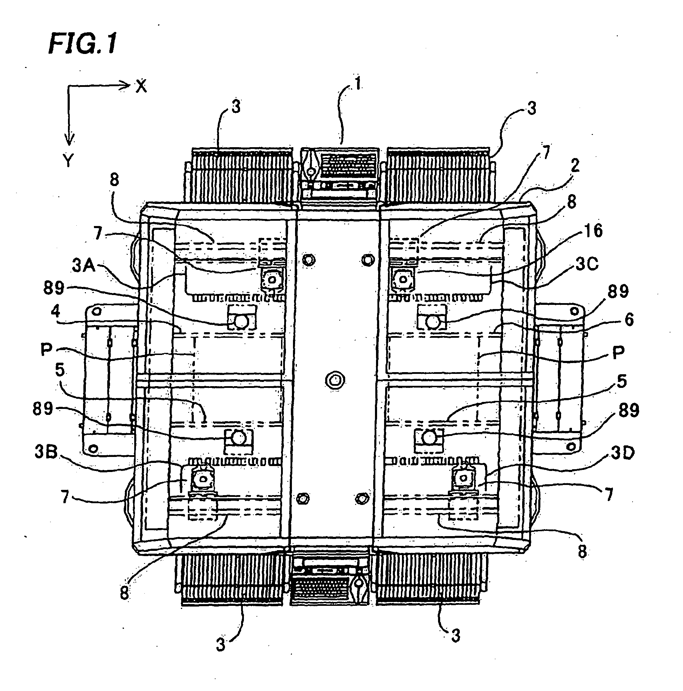

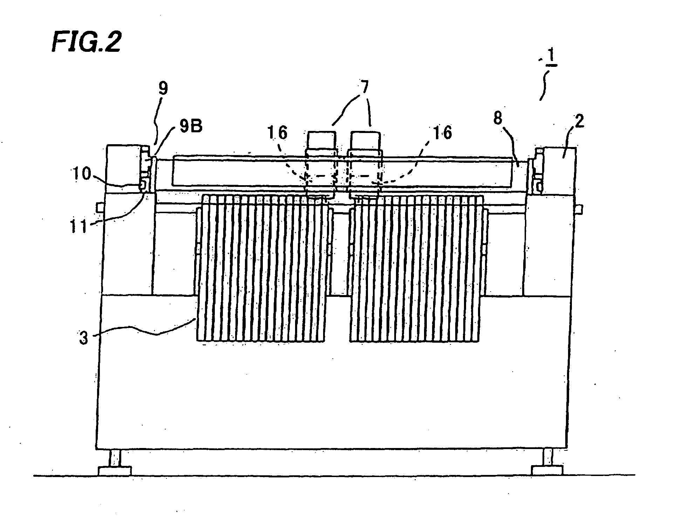

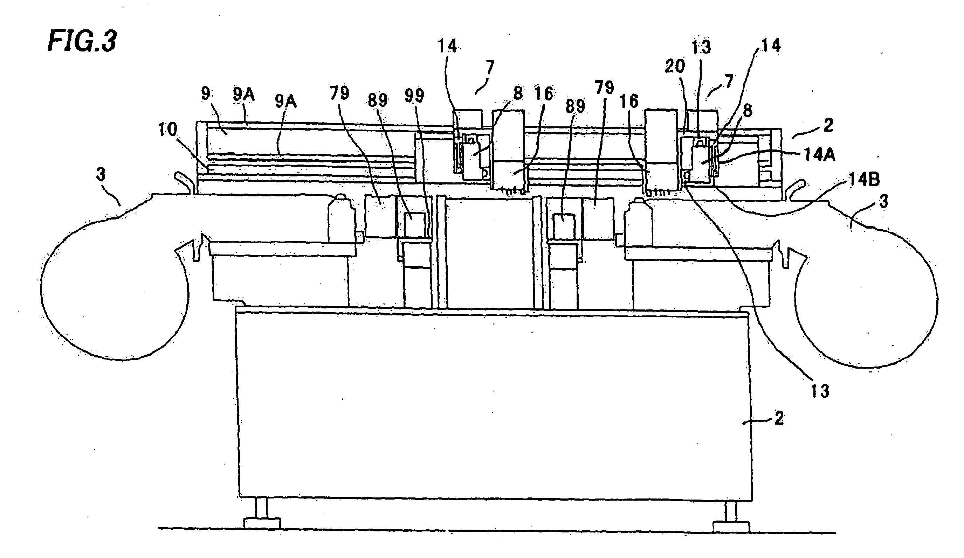

An embodiment of an electronic component mounting apparatus of the invention will be described with reference to the drawings. Fig. 1 is a plan view of an electronic component mounting apparatus 1, Fig. 2 is a front view of the electronic component mounting apparatus 1, and Fig. 3 is a right side view of the electronic component mounting apparatus 1. A plurality of component feeding units 3 for feeding a variety of electronic components one by one to each of component feeding positions (component pickup positions) is attachably and detachably aligned and fixed on feeder bases 3A, 3B, 3C, and 3D on a base 2 in the apparatus 1. A feed conveyer 4, a positioning portion 5, and a discharge conveyer 6 are provided between groups of the units 3 facing to each other. The feed conveyer 4 conveys a printed board P received from an upstream to the positioning portion 5, an electronic component is mounted on the printed board P positioned by a positioning device (not shown) in the positioning portion 5, and the printed board P is conveyed to the discharge conveyer 6.

A numeral 8 designates a pair of front and rear beams extending in an X direction provided on left and right portions of the mounting apparatus 1 respectively. Each of the beams 8 respectively moves in a Y direction above the printed board P on the positioning portion 5 or the component feeding positions (component pickup positions) of the component feeding units 3 as sliders 11 fixed to each of the beams 8 slide along a pair of left and right guides 10, driven by each of linear motors 9. Each of the linear motors 9 has a pair of upper and lower stationary members 9A fixed on the base 2 and a moving member 9B fixed to a lower part of an attachment board provided on each end of the beam 8.

Each of the beams 8 is provided with a mounting head body 7 which moves in a longitudinal direction, i.e., in the X direction along a guide 13 driven by the linear motor 14 and forms an X axis and Y axis as horizontal axes together with the beams 8. The linear motor 14 has a pair of front and back stationary members 14A fixed to the beam 8 and a moving member 14B provided on the mounting head body 7 and between the stationary members 14A.

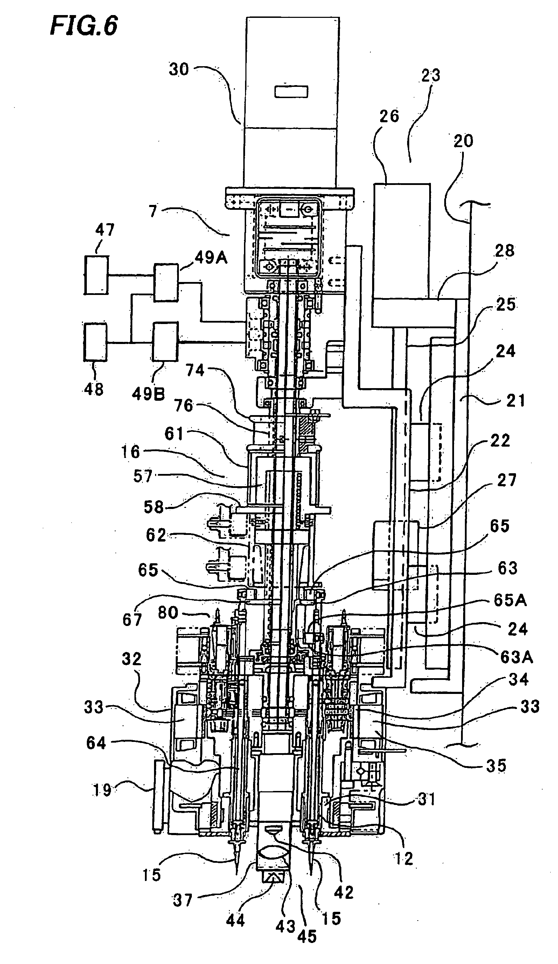

Each of the mounting head bodies 7 has a mounting head 16 having twelve suction nozzles 15 each fixed to and pulled down by each of twelve springs 12 (Fig. 6). A board recognition camera 19 is provided on the mounting head 16 in each of the mounting head bodies 7 and takes an image of a positioning mark (not shown) on the printed board P positioned on the positioning portion 5.

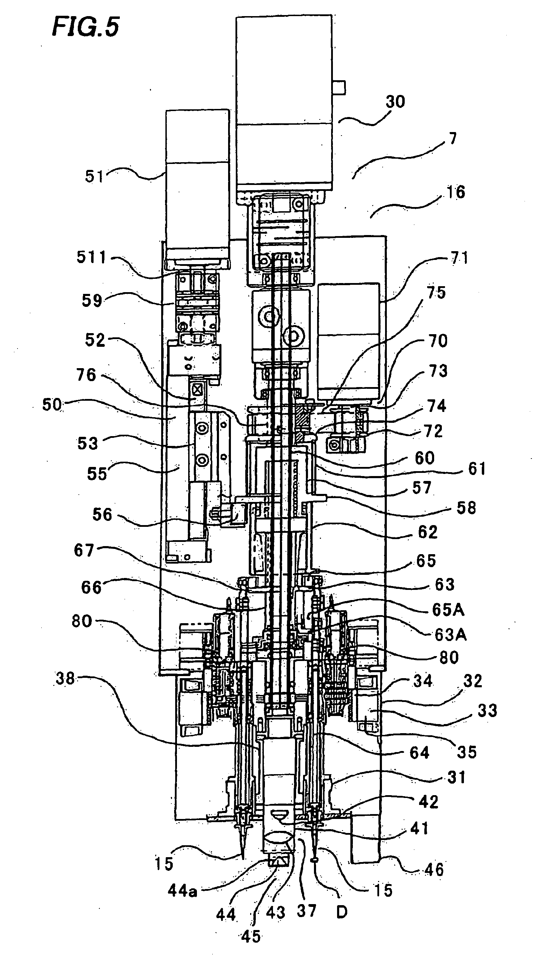

A vertical movement device for the mounting head 16 will be described in detail with reference to Figs. 5 and 6. A numeral 20 designates a board of the mounting head body 7 moving along the guide 13, and a numeral 21 designates a beam side base fixed to this board 20. A numeral 22 designates a mounting head side base fixed to upper and lower portions of the mounting head 16. A head vertical movement device 23 is provided between this mounting head side base 22 and the beam side base 21.

The head vertical movement device 23 has a guide 24 guiding the mounting head 16 when the mounting head 16 vertically moves, a ball screw 25 attached to the beam side base 21, a head vertical movement motor 26 vertically moving the mounting head 16 by rotating the ball screw 25, a vertical movement nut 27 engaged with the ball screw 25, and a support body 28 attached to the head vertical movement motor 26 and rotatably supporting an upper portion of the ball screw 25. The vertical movement nut 27 is fixed to the head side base 22. Thus, rotation of the ball screw 25 by rotation of the head vertical movement motor 26 makes the vertical movement nut 27 vertically move, resulting in vertical movement of the mounting head 16.

A numeral 30 designates a slip ring provided for communication between the mounting apparatus and the mounting head 16 and for power supply to a rotation motor of a nozzle support portion which will be described below. A numeral 31 designates a nozzle support body provided in a lower portion of the mounting head 16 and supporting each of twelve suction nozzles 15 provided on a circumference thereof at predetermined intervals, which are vertically movable. A numeral 32 designates an outer cylinder in a lower portion of the mounting head 16, and a numeral 33 designates a nozzle rotation motor as a pulse motor for θ rotation of the nozzle support body 31 provided between the outer cylinder 32 and the nozzle support body 31. A rotor 34 of this nozzle rotation motor 33 is provided on an outer circumference surface of the nozzle support body 31, being rotatable in a θ direction inside a stator 35 provided in the outer cylinder 32 together with the nozzle support body 31.

A numeral 37 designates a line sensor unit for detecting presence or absence, an attached posture (attachment state), and a lower end of the electronic component D, protruding downward from a center of the head support body 31. The line sensor unit 37 has a light emitting unit 45 and a light receiving unit 46. The light emitting unit 45 is provided in a lower end of the support body 38 in the almost center position of the mounting head 16, and has a light emitting element 42 such as an LED in an upper part of a cylindrical light emitting unit attachment body 41, a lens 43 below the light emitting element 42, and a reflector 44 having a conic reflective surface 44a provided below the lens 43. A light receiving unit 46 is fixed to a bottom surface of the outer cylinder 32, and has CCD elements as a plurality of light receiving elements for receiving light emitted from the light emitting element 42 through the reflector 44.

This enables differentiating a case where the electronic component is picked up with a normal position as shown in Fig. 5 from a case where the component is picked up with its wrong surface being attached to the suction nozzle, i.e., standing or slanting, since height of a lower end surface of the electronic component D can be detected by recognizing a border between the position receiving no light and the position receiving light in each of the CCD elements in each time when the nozzle support body 31 rotates after a pickup operation of an electronic component D is completed by the suction nozzle 15 provided on the mounting head 16 and selected for picking the component. In detail, after the suction nozzle 15 lowers, picks up the electronic component D from the component feeding unit 3 by suction, and rises up, the nozzle rotation motor 33 is driven to rotate the nozzle support body 31 and rotate the suction nozzle 15 holding the electronic component D by suction. When the electronic component D held by the suction nozzle 15 comes between the reflector 44 and the light receiving unit 46 during rotation of the suction nozzle 15, presence or absence and an attached posture of the component can be detected by detecting height of the lower end surface of the electronic component D at plural positions. Although the detection is performed during rotation and movement of the nozzle support body 31 in this embodiment, alternatively the detection can be performed with the rotation being stopped when the electronic component D comes between the reflector 44 and the light receiving unit 46.

In a case where the suction nozzle 15 does not hold the electronic component D by suction, light emitted from the light emitting element 42, which should be shielded (by the held electronic component), is received by the light receiving unit 46. Thus, a detection result is "absence" of the electronic component D, so that by an operation of a solenoid valve 82 as a vacuum valve switch effector, which will be described below, provided on a side of each of the nozzle axes 64, a vacuum path is disconnected from a vacuum source 47 to stop the vacuum suction, thereby preventing leakage. In a case where the electronic component is detected as being attached to the suction nozzle 15 at its wrong surface, i.e., with standing or slanting, the mounting head 16 and the suction nozzle 15 move to a position above a collection box 79, drops the electronic component D therein.

A numeral 50 designates a nozzle vertical movement device provided on the mounting head 16. Description will be made on this nozzle vertical movement device, hereafter. A numeral 51 designates a motor for vertically moving a nozzle (referred to as a nozzle vertical movement motor, hereafter) attached to the head side base 22, and a numeral 52 designates a ball screw connected with a rotation axis 511 of the nozzle vertical movement motor 51 through a connection member 59 and rotating driven by the nozzle vertical movement motor 51, a numeral 53 designates a vertical movement body engaged with the ball screw 52 and vertically moving by rotation of the ball screw 52, a numeral 55 designates a guide attached to the head side base 22 and guiding the vertical movement body 53 for vertical moving, and a numeral 56 designates a roller rotatably attached to a lower end of the vertical movement body 53.

Furthermore, a numeral 57 designates a first cylinder where a center axis 60 of the mounting head 16 penetrates a center thereof, a roundel 58 formed on the first cylinder 57 is positioned on the roller 56, the fist cylinder 57 being supported by the roller 56. The first cylinder 57 is formed of a ball spline, for example, and pulled downward by a spring 61 of which a lower end is attached to an upper surface of the roundel 58. This first cylinder 57 rotates by θ with θ rotation of a pulley which will be described below, and vertically moves together with a vertical movement of the vertical movement body 53 and a vertical movement of the roller 56. A numeral 62 designates a nozzle support member fixed to a lower portion of the first cylinder 57 and rotates by θ with the first cylinder 57. A vertical movement table 63 is formed on a lower end of this nozzle support member 62, horizontally lying in a circumference direction. This vertical movement table 63 vertically moves together with vertical movement of the first cylinder 57. The lowering of the vertical movement table 63 makes a predetermined suction nozzle 15 among a plurality of nozzles lower.

In detail, a roller 65 is rotatably attached to an upper end of each of the nozzle axes 64 extending upward from each of the suction nozzles 15. The roller 65 on the upper end of the nozzle axis 64 of the suction nozzle 15 selected by a nozzle selection device which will be described below lowers by lowering of the nozzle support member 62 and the vertical movement table 63 by lowering of the first cylinder 57, the roller 65 being positioned on an upper surface of the vertical movement table 63. In detail, when the vertical movement table 63 and the roller 65 lower to a position shown by the vertical movement table 63A and the roller 65A, for example, the predetermined nozzle 15 lower with this lowering. Furthermore, by controlling a rotation amount of the nozzle vertical movement motor 51 and adjusting a height where the vertical movement body 53 should stop during lowering, the suction nozzle 15 can lower by a predetermined stroke.

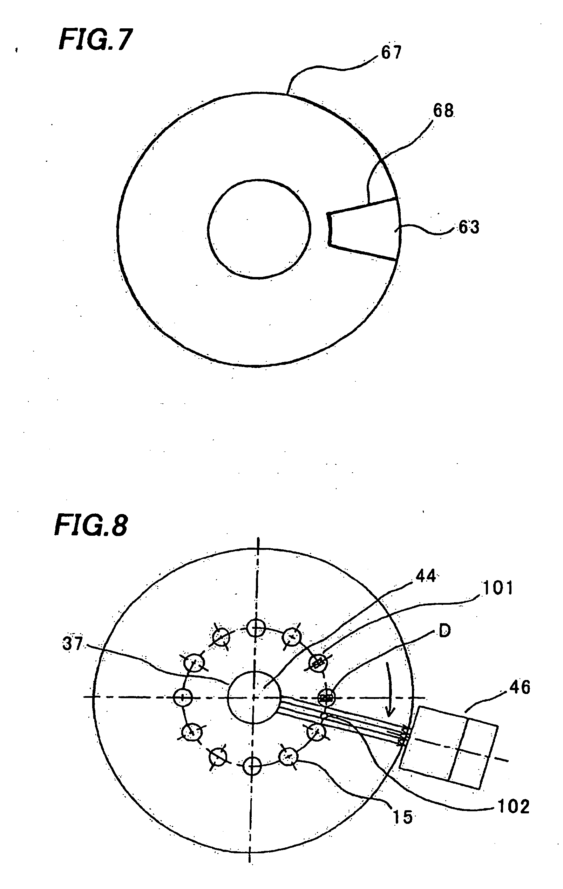

A numeral 66 designates a third cylinder provided under the nozzle support member 62, which is rotatable by θ. On an upper portion of this third cylinder 66, a fixing support piece 67, which has a disk like shape, is formed at the same height as that of the vertical movement table 63 of the nozzle support member 62 before lowered. The fixing support piece 67 is formed with a notch 68 for the vertical movement table 63 as shown in Fig. 7. Each of the rollers 65 on the upper ends of the nozzle axes 64 of the nozzles 15 except the above-described nozzle 15 to be lowered is supported by the fixing support piece 67. That is, the fixing support piece 67 has the notch 68 formed in a position of one of some-degree divided pieces thereof calculated by dividing the piece 67 equally into the same number of pieces as the number of the nozzles 15 in a circumference direction, for example, in a position of a 30-degree piece which is one of 12 divided pieces in this embodiment. The vertical movement table 63 of the nozzle support member 62 is positioned in this notch 68.

A numeral 70 designates a nozzle vertical position selection device provided on the mounting head 16, a numeral 71 designates a selection motor for aligning the notch 68 with a rotation angle of the nozzle that is to be vertically moved for picking or mounting the electronic component, a numeral 72 designates a first pulley fixed to a rotation axis 73 of the selection motor 71, a numeral 74 designates a second pulley rotatably supported by the center axis 60, a numeral 75 designates a belt stretched between the first pulley 72 and the second pulley 74, and a numeral 76 designates a cylindrical rotator provided on an outside of the center axis 60, extending downward from a center of the second pulley 74. The spring 61 is provided between the second pulley 74 and the roundel 58 of the first cylinder 57.

The first cylinder 57 is formed on an outside of outer circumference of the lower portion of the rotator 76. By the function of the first cylinder 57 as a ball spline, the first cylinder 57 rotates with rotation of the second pulley 74 and rotation of the rotator 76. Furthermore, the first cylinder 57 vertically moves with vertical movement of the vertical movement body 53 along the rotator 76.

In detail, when the nozzle for picking and mounting the electronic component D is to be vertically moved, the CPU 90 outputs an operation signal to the selection motor 71 based on the angle of the electronic component to be picked up and mounted by the suction nozzle 15, and the nozzle selection motor 71 is driven. Then, the first cylinder 57 rotates through the first pulley 72, the belt 75, the second pulley 74, and the rotator 76. Then, the nozzle support member 62 connected with the first cylinder 57 rotates together with the third cylinder 66, and the vertical movement table 63 of the nozzle support member 62 stops at the selected angle position. Then, the nozzle rotation motor 33 rotates by a signal sent from the CPU 90, the suction nozzle 15 moves, and the nozzle axis 64 and the roller 65 also move. With the roller 65 being positioned on the vertical movement table 63, the nozzle vertical movement motor 51 rotates, and the vertical movement body 53 lowers corresponding to the thickness of the electronic component to be picked up and mounted, so that the first cylinder 57 and the nozzle support member 62 lower and thus the vertical movement table 63 lowers, thereby lowering only the selected nozzle 15 by a predetermined stroke corresponding to the thickness of the electronic component.

A numeral 80 is an air switch valve switchable between air suction and air blow in each of the nozzles 15, being provided for each of the nozzles 15 at predetermined intervals in the circumference direction on the outer side of the nozzles. This air switch valve 80 has a case 81 provided in an upper portion thereof, and a solenoid valve 82 of which the upper portion is positioned inside this case 81 and electrical conduction is controlled by a signal from the CPU 90. The solenoid valve 82 has a circular electromagnet 83 provided on an inner surface of the case 81, a path switch body 85 provided with a cylindrical permanent magnet 84 corresponding to the electromagnet 83 in its upper portion and vertically moving inside the case 81 according to electrical conduction and electrical non-conduction through the electromagnet 83, and so on. An air blow path 86, a nozzle connection path 87, and a vacuum leading path 88 are formed between the path switch body 85 and a cylinder portion 81A in the lower portion of the case 81 in due order from upper to lower sides. Furthermore, the nozzle axis 64 has a nozzle axis path 100 connected with an inner path of the nozzle 15 and the nozzle connection path 87. By the vertical movement of the path switch body 85, the connection of the nozzle path 100 switches to between the vacuum leading path 88 and the air blow path 86 through the nozzle connection path 87.

In detail, when the path switch body 85 rises by electrical conduction of the solenoid valve 82 through the electromagnet 83, the vacuum leading path 88 and the nozzle connection path 87 are connected to each other, and the nozzle connection path 87 and the air blow path 86 are disconnected from each other. Therefore, the inner path of the suction nozzle 15 is connected to a vacuum source 47 through the nozzle axis path 100, the nozzle connection path 87, and the vacuum leading path 88, so that the suction nozzle 15 keeps vacuum suction of the electronic component. On the other hand, when the connection switch body 85 lowers by electrical non-conduction through the electromagnet 83, the vacuum leading path 88 connected with the vacuum source 47 and the nozzle connection path 87 are disconnected from each other, and the nozzle connection path 87 and the air blow path 86 are connected to each other. Therefore, the vacuum suction of the electronic component D by the suction nozzle 15 stops, and air from an air supply source 48 is blown in the inner path of the suction nozzle 15 through the air blow path 86, the nozzle connection path 87, and the nozzle axis path 100.

In this manner, the connection of the suction nozzle 15 with the vacuum source 47 and the air supply source 48 can be switched by electrical conduction and electrical non-conduction of the air switch valve 80 (the electromagnet 83 of the solenoid valve 82) provided for each of the suction nozzles 15. Thus, the air switch valve 80 for the selected suction nozzle 15 can be switched independently.

A numeral 49A designates a switch valve connected with the air switch valve 80 in one end, which switches its connection with the vacuum source 47 and the air supply source 48 so as to make the suction nozzle 15 suck and blow respectively. A numeral 49B designates an open-close valve connected with the air switch valve 80 in one end and with the air supply source 48 in another end. This is a valve used for mounting an electronic component by the suction nozzle 15 by establishing a state of blowing air from the air supply source 48 by its opening before the air switch valve 80 switches from air suction to air blow and then breaking vacuum when the air switch valve 80 switches to the air blow as the suction nozzle 15 picking the electronic component starts lowering.

A numeral 89 designates a component recognition camera. The component recognition camera 89 is provided on each of attachment boards 99 of the base 2 so that there are four cameras 89 in total each corresponding to each of the mounting heads 16. The camera 89 sequentially takes images of all the electronic components D picked up by the suction nozzles 15 to detect an amount of shifting from a proper position of the electronic component D on the suction nozzle 15 in X and Y directions and at rotating angles. The camera 89 can also take images of the plurality of the electronic components D at the same time. Furthermore, the component recognition camera 89 can recognize whether or not the electronic component D is held by suction by the suction nozzle 15 by taking an image.

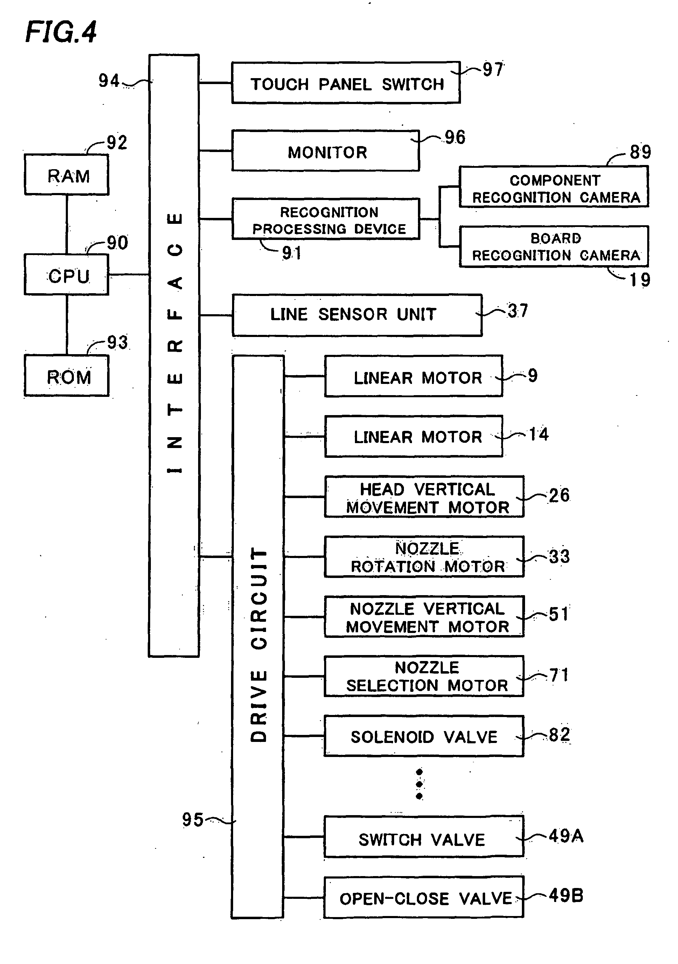

Next, description will be made with reference to a block diagram showing a control of the electronic component mounting apparatus 1 in Fig. 4. A numeral 90 designates the CPU (mounting control portion) as a control portion for controlling the mounting apparatus 1. The CPU 90 is connected with a RAM (random access memory) 92 and a ROM (read only memory) 93 through buses. The CPU 90 controls all operation for component mounting of the electronic component mounting apparatus 1 according to programs stored in the ROM 93 based on data stored in the RAM 92. That is, the CPU 90 controls driving of the linear motors 9 and 14, the head vertical movement motor 26, the nozzle rotation motor 33, the nozzle vertical movement motor 51, the nozzle selection motor 71, the solenoid valve 82, the open-close valve 49B and the switch valve 49A provided in each of the mounting heads 16, and so on through the interface 94 and the drive circuit 95.

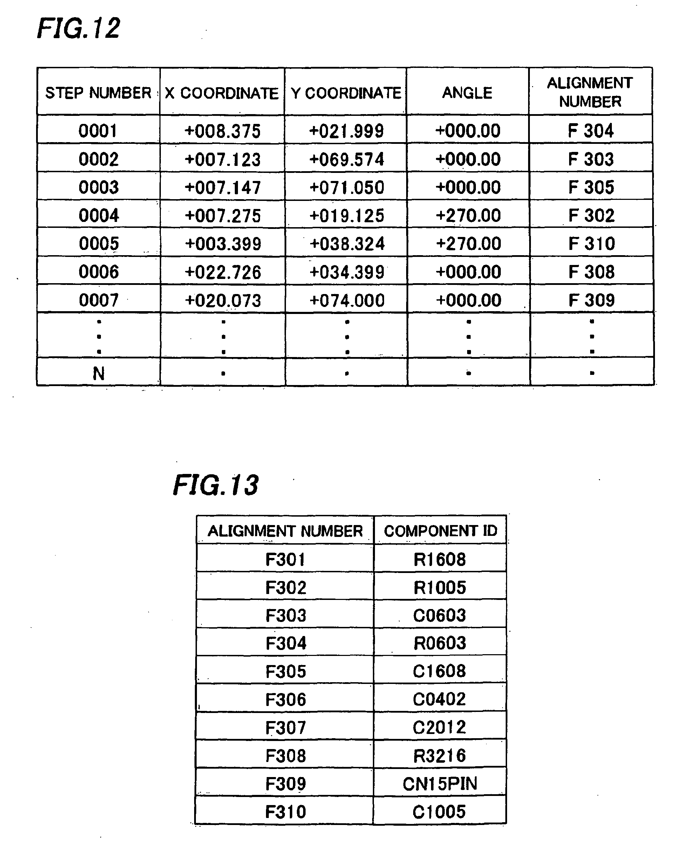

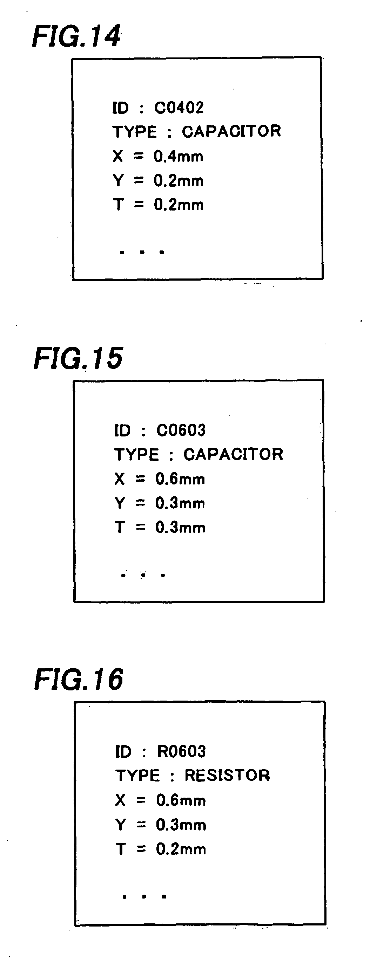

The RAM 92 is stored with mounting data on component mounting as shown in Fig. 12 which include the X and Y coordinates and an angle on the printed board, alignment numbers of the component feeding units 3, and so on in order of component mounting (in order of step number). Furthermore, the RAM 92 is stored with component disposition data as shown in Fig. 13 which include a type of the electronic component (component ID), and so on corresponding to alignment numbers of the component feeding units 3. The RAM 92 is further stored with component library data as shown in Figs. 14 to 16 which include the type, sizes in the X and Y directions and in the thickness direction (height), and so on of each of the electronic components (component ID). For example, as shown in Fig. 14, the component ID "C0402" is a capacitor in the type, and 0.4mm, 0.2mm, and 0.2mm in the sizes in the X direction, the Y direction, and the thickness direction respectively.

The RAM 92 is further stored with data on a height position where a lower surface of an electronic component does not contact a structure component of the electronic component mounting apparatus or an electronic component already mounted on a printed board for each of the electronic component mounting operations, a height position of a structure component, for example, a suppressor for each of the component feeding units 3 that supplies electronic components in the electronic component pickup operation, height of an original point of the suction nozzle 15 for each of the types thereof, a lowering speed of the suction nozzle 15 that lowers to a surface to be mounted with an electronic component in the electronic component mounting operation (that is previously stored in the RAM 92 as component library data for each of the types of the electronic components), a lowering speed of the suction nozzle 15 lowering to the component feeding unit (that is previously set based on the types of the electronic components), and a rotation speed of the mounting head 16 rotating driven by the head rotation motor 33.

A numeral 91 designates a component recognition processing device connected with the CPU 90 through the interface 94. In the component recognition processing device 91, images taken and stored by the component recognition camera 89 and the board recognition camera 19 undergo recognition processing.

The images taken by the component recognition camera 89 and the board recognition camera 19 are displayed on a monitor 96 as a display device. The monitor 96 is provided with various touch panel switches 97 and an operator operates the touch panel switches 97 for various settings including settings for informing.

The touch panel switches 97 include a glass substrate which is coated with a transparent conductive film on its whole surface and printed with electrodes on its four edges. When an operator touches one of the touch panel switches 97 in a state where minimal electric currents flow on the surface of the touch panel switches 97, current flows change at the four electrodes and coordinates of a touched position are calculated by a circuit board connected with the electrodes. If the calculated coordinates correspond to one of coordinates originally stored in the RAM 92, which will be described below, as a switch for executing a certain operation, the operation is executed.

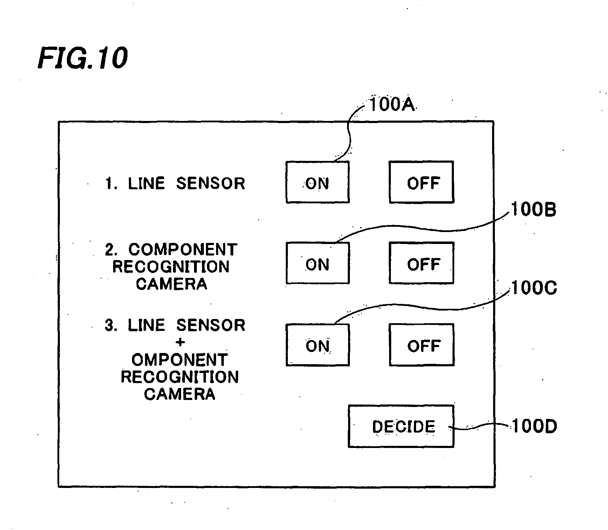

Under the structure described above, a screen as shown in Fig. 10 is displayed on the monitor 96, and then selection is made from the line sensor unit 37 only, the component recognition camera 89 only, and both the line sensor unit 37 and the component recognition camera 89, for use for detecting whether or not the suction nozzle 15 still holds the electronic component after the mounting operation of the electronic component on the printed board P. Suppose that the line sensor unit 37 only is selected for the detection, first. An operator pushes a switch portion 100A and then a decision switch 100D to set the detection by the line sensor unit 37 only. The set content is stored in the RAM 92, and the CPU 90 controls a detecting operation according to a program corresponding to the set content stored in the ROM 93.

This setting can be performed on each group of the electronic components having a same type or in mounting order in the mounting data of electronic components.

Hereafter, the picking and mounting operation of the electronic component D by the electronic component mounting apparatus 1 will be described. First, the printed board P is conveyed from upstream to the positioning portion 5 through the feed conveyer 4, and the positioning device starts a positioning operation.

Next, the CPU 90 forms pickup sequence data from the mounting data stored in the RAM 92. That is, the CPU 90 reads out data from the mounting data, decides a picking-up procedure of the suction nozzles 15, detects the last component feeding unit 3 which feeds the last electronic component D in a sequential picking-up process (12 components can be picked up for one mounting head 16 at maximum) and stores coordinates of a last pickup position of the component feeding unit 3 in the RAM 92, detects coordinates of a first mounting position of the component D after completing the sequential picking-up process (a position stored in mounting data before alignment) and stores the coordinates in the RAM 92.

Then, picking-up of the electronic components D is performed. In detail, the suction nozzles 15 corresponding to types of the electronic components pick up the electronic components to be mounted from the predetermined component feeding units 3 according to the mounting data and so on stored in the RAM 92 where the position of the X and Y coordinates on the printed board to be mounted with the component, a position at a rotation angle around a vertical axis, an alignment number and so on are specified.

For this pickup operation, by the linear motors 9 and 14 controlled by the CPU 90, the suction nozzle 15 of the mounting head 16 in the mounting head body 7 moves to a position above the first electronic component in the component feeding unit 3 which has the electronic components to be mounted. Each of the head bodies 7 moves in the Y direction by moving of the beam 8 along the pair of the guides 10 driven by the linear motor 9 and in the X direction along the guides 13 driven by the linear motor 14, both the linear motors 9 and 14 being driven by the drive circuit 95.

At this time, the predetermined component feeding unit 3 is already driven and the electronic component is ready to be picked up at a feeding position of the unit 3. Therefore, based on a signal outputted by the CPU 90 through the interface 94 and the drive circuit 95 during the movement of each of the mounting head bodies 7, the head vertical movement motor 26 rotates and the mounting head 16 lowers to a predetermined height along the guide 24, that is, the height where the suction nozzle 15 does not contact the other structure components such as the feeding units 3 at all. Then, when the suction nozzle 15 for picking the electronic component first is being shifted from a pickup position, that is, a pickup position 101 (set this position as 0 degree) shown in Fig. 8 which is a schematic bottom view of the mounting head 16, the CPU 90 outputs a signal to move the suction nozzle 15 to the pickup position 101 shown in Fig. 8, and the nozzle rotation motor 33 that forms the rotation mechanism of the suction nozzle together with the nozzle support body 31 rotates by this signal. By the drive of the nozzle rotation motor 33, the nozzle support body 31 of the mounting head 16 rotates by θ around the center axis 60.

Then, the suction nozzle 15 is ready to start lowering at the time when the roller 65 moves onto the vertical movement table 63.

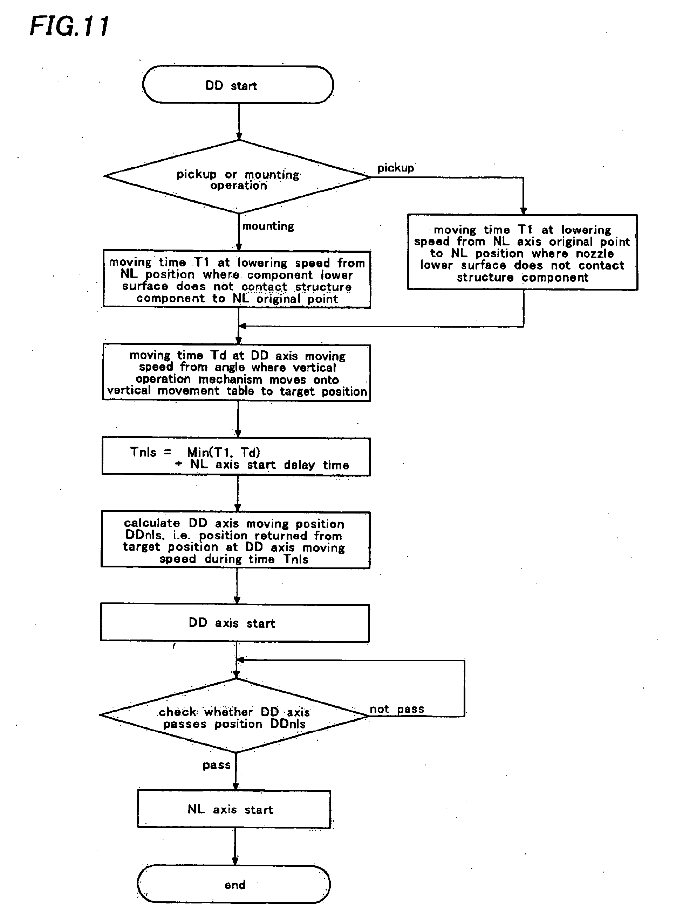

Hereafter, a relation between the rotation operation of the nozzle support body 31 in the pickup operation of the electronic component by the suction nozzle 15 and timing to start the lowering of the suction nozzle 15, i.e., timing to start the nozzle vertical movement motor 51 will be explained referring to a flow chart of Fig. 11.

When the suction nozzle 15 is to lower in the described pickup operation of the electronic component by the suction nozzle 15, the CPU 90 calculates height H1 (a height position of the lower surface of the lowering suction nozzle immediately before the lower surface contacts the suppressor, i.e., a height position which provides no contact between the suction nozzle and the suppressor unless the suction nozzle lowers more) where the lower surface of the suction nozzle (NL axis) 15 does not contact the other structure component, for example, the suppressor as the upper portion of a tape feeder supplying a component from a component storage tape, that is the upper portion of the component feeding unit 3, based on the height position of the suppressor and the size of the suction nozzle 15 (NL axis) that are stored in the RAM 92, and calculates a distance L1 from the original point of the suction nozzle 15 before it starts lowering to the height position H1.

Then, the CPU 90 calculates lowering time (moving time) T1 taken to lower the suction nozzle 15 from the original point to the height H1 based on the distance L1 and the lowering speed of the suction nozzle 15 previously set and stored in the RAM 92.

Then, the CPU 90 calculates moving time Td taken to move the roller 65 that is the vertical operation mechanism of the suction nozzle 15 from the time when the roller 65 reaches the vertical movement table 63 by the rotation of the nozzle support body 31, that is, from the time when the roller 65 reaches a position on the vertical movement table 63 where the roller 65 does not contact the fixing support piece 67 even when the vertical movement table 63 starts lowering until the time when the roller 65 reaches the center of the vertical movement table 63 that is a target position at a rotation speed of the nozzle support body 31 by the rotation of the nozzle rotation motor 33. That is, the CPU 90 calculates the moving time Td based on the rotation speed of the nozzle support body 31 for each of the types of the electronic components previously stored in the RAM 92 and the moving distance of the roller 65 from the edge of the vertical movement table 63 to the center thereof.

Then, the CPU 90 selects the shorter one of the calculated lowering time T1 and moving time Td, adds the start delay time of the nozzle vertical movement motor 51 to the selected time to calculate base time Tnls that is the basis of determination of the timing to start the nozzle vertical movement motor 51, and stored this base time in the RAM 92.

Then, the CPU 90 calculates a distance of movement during the base time Tnls at the rotation speed of the nozzle support body 31, calculates a position returned from the center of the vertical movement table 63 by the calculated distance, as a position for starting nozzle vertical movement motor 51, that is, as a start position (moving position) DDnls, and stores this position in the RAM 92.

Then, when the nozzle rotation motor 33 starts (DD axis starts) by a start signal inputted by the CPU 90 through the interface 94 and the drive circuit 95, the nozzle support body 31 starts rotating to move suction nozzle 15 and the roller 65. The CPU 90 observes the position of the nozzle support body 31 (DD axis), that is, the position of the roller 65 moving toward the vertical movement table 63. When the CPU 90 recognizes that the roller 65 passes the start position DDnls, the CPU 90 outputs a start signal to the nozzle vertical movement motor 51. The nozzle vertical movement motor 51 inputted with the start signal starts after the start delay time, and the vertical movement body 53 and the vertical movement table 63 start lowering by the rotation of the ball screw 52.

Then, the nozzle 15 lowers toward the predetermined height, that is, the height suitable for picking the electronic component from the predetermined feeding unit 3 while it is moving in the X and Y directions (the horizontal direction). That is, the suction nozzle 15 reaches the electronic component pickup position on the component feeding unit 3 and reaches the height suitable for picking up the electronic component simultaneously.

In this manner, when the suction nozzle 15 lowers for picking up the electronic component, the CPU 90 calculates the base time Tnls by adding the start delay time of the nozzle vertical movement motor 51 stored in the RAM 92 to the shorter one of the calculated lowering time (moving time) T1 taken to lower the suction nozzle 15 from the original point to the height H1 and the moving time Td calculated from the rotation speed of the nozzle support body 31 set for each of the types of the electronic components previously stored in the RAM 92 and the distance of movement of the roller 65 from the edge of the vertical movement table 63 to the center thereof. Then, the CPU 90 calculates the distance of movement of the suction nozzle 15 during this base time Tnls based on this base time Tnls and the rotation speed of the nozzle support body 31, and calculates the position returned from the center of the vertical movement table 63 by the calculated distance as the position for starting the nozzle vertical movement motor 51, that is, as the start position DDnls. Then, the nozzle rotation motor 33 starts (DD axis starts), the nozzle support body 31 starts rotating, and when the CPU 90 recognizes that the suction nozzle 15 and the roller 65 pass the start position DDnls the CPU 90 outputs a start signal to the nozzle vertical movement motor 51. This enables the CPU 90 to output a start signal to the nozzle vertical movement motor 51 as early as possible based on the shorter one of the lowering time T1 and the moving time Td. This realizes the earlier timing to start the lowering of the suction nozzle 15, and further the earlier timing to start the picking of the electronic component by the suction nozzle 15.

The reason to select the shorter one from the lowering time T1 and the moving time Td is to avoid the start of the lowering of the vertical movement table 63 before the suction nozzle 15 reaches the vertical movement table 63 and to avoid the contact of the suction nozzle 15 and the other component due to the completion of the lowering of the suction nozzle 15 before the suction nozzle reaches the center of the vertical movement table 63. For example, in the case where the lowering time T1 is selected when the lowering time T1 is longer than the moving time Td, the base time increases and the vertical movement table 63 starts lowering before the suction nozzle 15 reaches the vertical movement table 63. On the contrary, in the case where the moving time Td is selected when the moving time Td is longer than the lowering time T1, the suction nozzle 15 does not reach the center of the vertical movement table 63 yet when the suction nozzle 15 completes its lowering, and thus the suction nozzle 15 moves to the center of the vertical movement table 63 in the horizontal direction after the suction nozzle 15 completes its lowering, so that there is a possibility that the suction nozzle 15 contacts the other component during its horizontal movement.

It is possible that the suction nozzle 15 starts lowering during its rotation toward the pickup position 101, so that the suction nozzle 15 can perform its rotation to the pickup position 101 and its lowering at the same time. This can reduce the time required for the pickup operation of the electronic component D, resulting in reduction of the time required for mounting the electronic component on the printed board. The rotation of the suction nozzle 15 starts while the mounting head 16 is moving in X and Y directions like its lowering.

When the suction nozzle 15 reaches the pickup position 101 and the height suitable for picking the electronic component, as described above, the solenoid valve 82 corresponding to the suction nozzle 15 rises by electrical conduction based on a signal from the CPU 90 and a path switch body 85 rises. Then, the vacuum leading path 88 and the nozzle connection path 87 are connected to each other, and the nozzle connection path 87 and the air blow path 86 are disconnected. The inner path of the suction nozzle 15 is connected to the vacuum source 47 through the nozzle axis path 100, the nozzle connection path 87, the vacuum leading path 88, and the switch valve 49A switched to the suction side, and the suction nozzle 15 keeps the vacuum suction of the electronic component.

When the pickup operation of the electronic component by the suction nozzle 15 is completed as described above, the CPU 90 outputs a signal to the nozzle vertical movement motor 51, and based on this signal the nozzle vertical movement motor 51 rotates in the direction for moving the suction nozzle 15 upward and the vertical movement body 53 rises to a predetermined height, that is, the height before the body 53 lowers by the rotation of the ball screw 52.

Then, when an electronic component is to be picked up from the different component feeding unit 3, while the mounting head body 7 moves in the X and Y directions by the operation of the linear motors 9 and 14, the suction nozzle 15 is shifted and a suction nozzle 15 which is located next to the suction nozzle 15 holding the electronic component by suction and is to pick up an electronic component next moves toward the position suitable for picking the electronic component in the X and Y directions.

The CPU 90 outputs a signal to the nozzle vertical movement motor 51, and simultaneously outputs a signal to pick the electronic component by the suction nozzle 15 next to the suction nozzle 15. In detail, the CPU 90 outputs a signal to locate the next suction nozzle 15 in the position above the component feeding portion of the component feeding unit 3 supplying the electronic component to be picked up and to locate the suction nozzle 15 in the vertical movement position of the nozzle support body 31. Then, by the driving of each of linear motors 9 and 14 and the rotation of the nozzle rotation motor 33 based on the signal, the suction nozzle 15 moves to above the component feeding unit 3 supplying the electronic component and rotates to the same vertical movement position as the vertical movement position where the suction nozzle 15 is located previously.

Then, in the similar manner to the case of the previous suction nozzle 15, when the nozzle vertical movement motor 51 rotates, and the solenoid valve 82 corresponding to the suction nozzle 15 operates based on the signal from the CPU 90, the path switch body 85 rises, the vacuum leading path 88 and the nozzle connection path 87 are connected with each other, the inner path of the suction nozzle 15 is connected with the vacuum source 47 through the nozzle axis path 100, the nozzle connection path 87, the vacuum leading path 88, and the switch valve 49A switched to the suction side, and the suction nozzle 15 keeps holding the electronic component by vacuum suction.

After then, in a case where the electronic components can be picked up in sequence by the mounting head 16, a multiple sequential pickup is performed (the electronic components D are sequentially picked up as many as possible) by using each of the remaining suction nozzles selected from twelve suction nozzles 15 provided on the nozzle support body 31, that is, by using each of the remaining suction nozzles selected from the suction nozzles from next one to twelfth one in the similar manner to the case of the previous suction nozzles 15. That is, the electronic components supplied at the component feeding units 3 for the remaining suction nozzles 15 are sequentially picked up by the suction nozzles 15, by the vertical movement of each of the suction nozzles 15 performed when the nozzle support body 32 stops while intermittently rotating by the rotation of the nozzle rotation motor 33.

Then, in this electronic component pickup operation by each of the suction nozzles 15, the line sensor unit 37 detects the presence or absence and the attached posture of the electronic component. In detail, the light receiving unit 46 of the line sensor unit 37 is provided in the position shifted by, for example, 45 degrees from the pickup position 101 shown in Fig. 8. When the suction nozzle 15 holding the electronic component passes the detection position 102 shown in Fig. 8 during the intermittent rotation of the nozzle support body 32 in the arrow direction, the line sensor unit 37 detects the presence or absence and the attached posture of the electronic component at the lower end of the suction nozzle 15 for all the electronic components by rotating the mounting head 16 one time as described above.

Then, in a case where there is an electronic component detected as being attached to the suction nozzle 15 at its wrong surface, i.e., with standing or slanting, an individual discharge (collection) operation where the mounting head 16 and the suction nozzle 15 moves to the position above an collection box 79 and drops the electronic component D therein is performed for each of the electronic components before the recognition and the mounting of the electronic component.

Then, the component recognition camera 89 takes an image of the electronic component and the recognition processing device 91 performs the component recognition operation such as recognition processing after all the individual discharge operations are completed, or the component recognition operation is performed when there is no electronic component detected as wrong in attached posture, and the mounting operation of the electronic component on the printed board P is performed.

In detail, the CPU 90 controls the linear motors 9 and 14 so as to move the suction nozzle 15 to the position of mounting coordinates on the printed board P positioned on the positioning portion 5, taking account of the recognition processing result received from the recognition processing device 91. The beam 8 moves in the Y direction along the pair of guides 10 by the linear motor 9, and the mounting head body 7 moves in the X direction along the guide 13 by linear motor 14, both the linear motor 9 and the linear motor 14 being driven by the drive circuit 95. The CPU 90 controls the nozzle rotation motor 33, the head vertical movement motor 26, and the nozzle vertical movement motor 51 to mount the electronic component on the printed board P.

Hereafter, description will be given on a relation between the rotation operation of the nozzle support body 31 and the timing to start the lowering of the suction nozzle 15, that is, timing to start the nozzle vertical movement motor 51 in the control of the start of nozzle vertical movement motor 51 when the suction nozzle 15 is to mount the electronic component the suction nozzle 15 holds by suction on the printed board, referring to the flow chart of Fig. 11 like in the pickup operation.

First, the CPU 90 calculates a height position H2 of the suction nozzle 15 (a height position of the lower surface of the component the lowering suction nozzle holds immediately before the lower surface contacts the component etc on the printed board, i.e., a height position which provides no contact between the lower surface of the component the suction nozzle holds and the component etc on the printed board unless the suction nozzle lowers more) where the lower surface of the held electronic component does not contact the structure component on the printed board, for example, a pre-mounted component or the like, and calculates a distance L1 from the original position of the suction nozzle 15 before it starts lowering to the height position H2.

Then, the CPU 90 subtracts a safe distance L2 from the structure components from the distance L1, the safe distance L2 being set in the RAM 92 in advance, to calculate a lowering distance L3 of the suction nozzle 15 from the original position, and calculates time (moving time) T1 taken to lower the suction nozzle 15 in this lowering distance at its lowering speed.

Then, the CPU 90 calculates moving time Td taken to move the roller 65 as the vertical operation mechanism of the suction nozzle 15 from the time when the roller 65 reaches the vertical movement table 63 until the time when the roller 65 reaches the center of the vertical movement table 63 that is the target position at the rotation speed of the nozzle support body 31 by the rotation of the nozzle rotation motor 33, in the similar manner to the above-described pickup operation.

Then, the CPU 90 selects the shorter one of the lowering time T1 and the moving time Td, adds the start delay time of the nozzle vertical movement motor 51 to the selected time to calculate the base time Tnls that is the basis of determination of timing to start the nozzle vertical movement motor 51, and stores the time Tnls in the RAM 92. Then, the CPU 90 calculates a moving distance during the base time Tnls at the rotation speed of the nozzle support body 31, calculates the position returned from the center of the vertical movement table 63 by the calculated distance as the start position DDnls for starting the nozzle vertical movement motor 51, and stores this position in the RAM 92.

Then, when the nozzle rotation motor 33 starts by a start signal inputted by the CPU 90 through the interface 94 and the drive circuit 95 (DD axis starts), the nozzle support body 31 starts rotating to move the suction nozzle 15 and the roller 65. The CPU 90 observes the position of the roller 65 that is the position of the nozzle support body 31 (DD axis) while the roller 65 is moving toward the vertical movement table 63, and when the CPU 90 recognizes that the roller 65 passes the start position DDnls the CPU 90 outputs a start signal to the nozzle vertical movement motor 51. The nozzle vertical movement motor 51 inputted with the start signal starts after the start delay time, and thus the vertical movement body 53 and the vertical movement table 63 start lowering by the rotation of the ball screw 52.

Then, the nozzle 15 moves in the X and Y directions (horizontal direction) and simultaneously lowers toward the predetermined height, that is, the previously set height suitable for mounting the electronic component on the printed board. That is, the suction nozzle 15 reaches the electronic component mounting position on the printed board and reaches the height suitable for mounting the electronic component simultaneously.

In this manner, when the suction nozzle 15 is to lower for mounting the electronic component, too, the CPU 90 calculates the base time Tnls by adding the start delay time of the nozzle vertical movement motor 51 stored in the RAM 92 to the shorter one of the lowering time (moving time)T1 taken to lower the suction nozzle 15 from the original point to the height H2 and the moving time Td of the roller 65 calculated from the rotation speed set for each of the types of the electronic components previously stored in the RAM 92 and the distance of the movement of the roller 65 from the edge of the vertical movement table 63 to the center thereof, calculates the distance of movement of the suction nozzle 15 based on the base time Tnls and the rotation speed of the nozzle support body 31, and calculates the position returned from the center of the vertical movement table 63 by the calculated distance as the position for starting the nozzle vertical movement motor 51 for mounting the electronic component, that is, the start position DDnls. Then, the nozzle rotation motor 33 starts (DD axis starts), the nozzle support body 31 starts rotating, and when the CPU 90 recognizes that the suction nozzle 15 and the roller 65 pass the start position DDnls the CPU 90 outputs a start signal to the nozzle vertical movement motor 51. This enables the CPU 90 to output a start signal for the nozzle vertical movement motor 51 as early as possible based on the shorter one of the lowering time T1 and the moving time Td, thereby realizing the earlier timing to start the lowering of the suction nozzle 15 and further the earlier timing to start mounting the electronic component.

When the electronic component is to be mounted, the corresponding air switch valve 80 is switched to the air blow side when the suction nozzle 15 holding the electronic component by suction starts lowering, and the vacuum suction of the suction nozzle 15 is broken by air from the air supply source 48 through the open-close valve 49B, and the electronic component is mounted on the printed board P. In detail, when the suction nozzle 15 lowers, the solenoid valve 82 corresponding to the suction nozzle 15 is switched from the electrical conduction state to the electrical non-conduction state based on a signal from the CPU 90, the vacuum source 47 is disconnected to stop the vacuum suction operation of the suction nozzle 15, the air from the air supply source 48 is blown in the inner path of the suction nozzle 15 through the air blow path 86 and the nozzle connection path 87, and the electronic component is mounted on the printed board P.

When the pickup operation of the electronic component by the first suction nozzle 15 is completed as described above, the CPU 90 outputs a signal to the nozzle vertical movement motor 51. Based on this signal, the nozzle vertical movement motor 51 rotates in the direction for raising the first suction nozzle 15, the ball screw 52 rotates, and the vertical movement body 53 rises to the predetermined height, i.e. the height before it lowers. Then, the electronic components held by the other suction nozzles 15 by suction are also mounted on the printed board sequentially in the similar manner to the above.

Although the particular embodiment of the invention has been disclosed in detail, it will be recognized that variations or modifications of the disclosed apparatus are possible based on the disclosure for those skilled in the art and lie within the scope of the present invention.

## Claims

1. An electronic component mounting apparatus having a component feeding unit (3) supplying an electronic component (D), a suction nozzle (15) picking up the electronic component supplied by the component feeding unit (3) by suction, a mounting head (16) mounted with the suction nozzle (15), a rotation mechanism (33) rotating the mounting head (16) around a vertical axis and a vertical movement table (63) vertically moving the suction nozzle (15) by operation of a vertical movement mechanism (51), and mounting the electronic component (D) picked up by suction by the suction nozzle (15) on a printed board (P) by vertically moving the suction nozzle (15), the electronic component mounting apparatus comprising:
a control device (90) calculating lowering time taken to lower the suction nozzle (15) to height (H2) where a lower surface of the electronic component (D) held by suction by the suction nozzle (15) does not contact other electronic component (D) mounted on the printed board (P), calculating moving time taken to move the suction nozzle (15) by rotation from an edge of the vertical movement table (63) to a target position on the vertical movement table (63), calculating base time by adding start delay time of the vertical movement mechanism (51) to shorter one of the lowering time and the moving time, calculating a moving distance of movement of the suction nozzle (15) by rotation during the base time, determining a position returned from the target position on the vertical movement table (63) by the moving distance as a start position for the vertical movement mechanism (51), and starting the vertical movement mechanism (51) when the control device (90) recognizes that the suction nozzle (15) passes the start position by rotation.

2. The electronic component mounting apparatus of claim 1, further comprising a memory (92) storing size data of the electronic component (D), data on height where the lower surface of the electronic component (D) does not contact other electronic component (D) mounted on the printed board (P), height of the suction nozzle (15) before it starts lowering, and a lowering speed and a rotation speed of the suction nozzle (15).

3. An electronic component mounting apparatus having a component feeding unit (3) supplying an electronic component (D), a suction nozzle (15) picking up the electronic component (D) supplied by the component feeding unit (3) by suction, a mounting head (16) mounted with the suction nozzle (15), a rotation mechanism (33) rotating the mounting head (16) around a vertical axis and a vertical movement table (63) vertically moving the mounting head (16) by operation of a vertical movement mechanism (51), and mounting the electronic component (D) picked up by suction by the suction nozzle (15) on a printed board (P) by vertically moving the suction nozzle (15), the electronic component mounting apparatus comprising:
a control device calculating lowering time taken to lower the suction nozzle (15) to a height (H1) where the suction nozzle (15) does not contact the component feeding unit (3), calculating moving time taken to move the suction nozzle (15) by rotation from an edge of the vertical movement table to a target position on the vertical movement table(63), calculating base time by adding start delay time of the vertical movement mechanism (51) to shorter one of the lowering time and the moving time, calculating a moving distance of movement of the suction nozzle (15) by the rotation mechanism (33) during the base time, determining a position returned from the target position on the vertical movement table (63) by the moving distance as a start position for the vertical movement mechanism (51), and starting the vertical movement mechanism (51) when the control device recognizes that the suction nozzle (15) passes the start position by rotation.

4. The electronic component mounting apparatus of claim 3, further comprising a memory (92) storing size data of the electronic component (D), data on height where the suction nozzle (15) does not contact the component feeding unit (3), height of the suction nozzle (15), and a lowering speed of the suction nozzle (15).

5. The electronic component mounting apparatus of claim 1 or 3, wherein the target position on the vertical movement table (63) is located at a center of the vertical movement table (63).

## Patentansprüche

1. Vorrichtung zur Montage von elektronischen Bauteilen, umfassend eine Bauteilzuführeinheit (3), die ein elektronisches Bauteil (D) zuführt, eine Saugdüse (15), die das von der Bauteilzuführeinheit (3) zugeführte elektronische Bauteil (D) durch Ansaugen aufnimmt, einen Montagekopf (16), der an der Saugdüse (15) befestigt ist, einen Drehmechanismus (33), der den Montagekopf (16) um eine vertikale Achse dreht, und einen Vertikalbewegungstisch (63), der die Saugdüse (15) durch Betätigung des Vertikalbewegungsmechanismus (51) vertikal bewegt und das durch die Saugdüse (15) durch Ansaugen aufgenommene elektronische Bauteil (D) auf einer Leiterplatte (P) montiert, indem er die Saugdüse (15) vertikal bewegt, wobei die Vorrichtung zur Montage von elektronischen Bauteilen Folgendes umfasst:
eine Steuervorrichtung (90), die die Absenkzeit berechnet, die das Absenken der Saugdüse (15) auf eine Höhe (H2) dauert, auf der eine Unterseite des durch Ansaugen durch die Saugdüse (15) gehaltenen elektronischen Bauteils (D) kein anderes elektronisches Bauteil (D), das auf der Leiterplatte (P) montiert ist, berührt, die Bewegungszeit berechnet, die das Bewegen der Saugdüse (15) durch Drehen von einem Rand des Vertikalbewegungstisches (63) in eine Sollposition auf dem Vertikalbewegungstisch (63) dauert, die Grundzeit durch Hinzufügen einer Startverzögerungszeit des Vertikalbewegungsmechanismus (51) zu der kürzeren der Absenkzeit und Bewegungszeit berechnet, eine Bewegungsstrecke der Saugdüse (15) durch Drehung während der Grundzeit berechnet, eine Rückkehrposition von der Sollposition auf dem Vertikalbewegungstisch (63) durch die Bewegungsstrecke als eine Startposition für den Vertikalbewegungsmechanismus (51) bestimmt und den Vertikalbewegungsmechanismus (51) startet, wenn die Steuervorrichtung (90) erkennt, dass die Saugdüse (15) durch Drehen die Startposition passiert.

2. Vorrichtung zur Montage von elektronischen Bauteilen nach Anspruch 1, die weiterhin einen Speicher (92) umfasst, der Größendaten des elektronischen Bauteils (D), Daten über die Höhe, auf der die Unterseite des elektronischen Bauteils (D) kein anderes elektronisches Bauteil (D), das auf der Leiterplatte (P) montiert ist, berührt, die Höhe der Saugdüse (15), bevor sie beginnt, sich abzusenken, und eine Absenkgeschwindigkeit und eine Drehgeschwindigkeit der Saugdüse (15) speichert.

3. Vorrichtung zur Montage von elektronischen Bauteilen, umfassend eine Bauteilzuführeinheit (3), die ein elektronisches Bauteil (D) zuführt, eine Saugdüse (15), die das von der Bauteilzuführeinheit (3) zugeführte elektronische Bauteil (D) durch Ansaugen aufnimmt, einen Montagekopf (16), der an der Saugdüse (15) befestigt ist, einen Drehmechanismus (33), der den Montagekopf (16) um eine vertikale Achse dreht, und einen Vertikalbewegungstisch (63), der den Montagekopf (16) durch Betätigung des Vertikalbewegungsmechanismus (51) vertikal bewegt und das durch die Saugdüse (15) durch Ansaugen aufgenommene elektronische Bauteil (D) auf einer Leiterplatte (P) montiert, indem er die Saugdüse (15) vertikal bewegt, wobei die Vorrichtung zur Montage von elektronischen Bauteilen Folgendes umfasst:
eine Steuervorrichtung, die die Absenkzeit berechnet, die das Absenken der Saugdüse (15) auf eine Höhe (H1) dauert, auf der die Saugdüse (15) die Bauteilzuführeinheit (3) nicht berührt, die Bewegungszeit berechnet, die das Bewegen der Saugdüse (15) durch Drehen von einem Rand des Vertikalbewegungstisches (63) in eine Sollposition auf dem Vertikalbewegungstisch (63) dauert, die Grundzeit durch Hinzufügen einer Startverzögerungszeit des Vertikalbewegungsmechanismus (51) zu der kürzeren der Absenkzeit und der Bewegungszeit berechnet, eine Bewegungsstrecke der Saugdüse (15) durch den Drehmechanismus (33) während der Grundzeit berechnet, eine Rückkehrposition von der Sollposition auf dem Vertikalbewegungstisch (63) durch die Bewegungsstrecke als eine Startposition für den Vertikalbewegungsmechanismus (51) bestimmt und den Vertikalbewegungsmechanismus (51) startet, wenn die Steuervorrichtung erkennt, dass die Saugdüse (15) durch Drehen die Startposition passiert.

4. Vorrichtung zur Montage von elektronischen Bauteilen nach Anspruch 3, die weiterhin einen Speicher (92) umfasst, der Größendaten des elektronischen Bauteils (D), Daten über die Höhe, auf der die Saugdüse (15) die Bauteilzuführeinheit (3) nicht berührt, die Höhe der Saugdüse (15), und eine Absenkgeschwindigkeit der Saugdüse (15) speichert.

5. Vorrichtung zur Montage von elektronischen Bauteilen nach Anspruch 1 oder 3, wobei sich die Sollposition auf dem Vertikalbewegungstisch (63) in einer Mitte des Vertikalbewegungstisches (63) befindet.

## Revendications

1. Dispositif de montage de composants électroniques comportant une unité d'alimentation en composants (3) fournissant un composant électronique (D), une buse d'aspiration (15) prenant le composant électronique fourni par l'unité d'alimentation en composants (3) par aspiration, une tête de montage (16) pourvue de la buse d'aspiration (15), un mécanisme de rotation (33) faisant tourner la tête de montage (16) autour d'un axe vertical et une table de déplacement vertical (63) déplaçant verticalement la buse d'aspiration (15) par la mise en oeuvre d'un mécanisme de déplacement vertical (51), et montant le composant électronique (D) pris par aspiration par la buse d'aspiration (15) sur une carte imprimée (P) en déplaçant verticalement la buse d'aspiration (15), le dispositif de montage de composants électroniques comprenant :
un dispositif de commande (90) calculant un temps d'abaissement nécessaire pour abaisser la buse d'aspiration (15) à une hauteur (H2) à laquelle une surface inférieure du composant électronique (D) maintenu par aspiration par la buse d'aspiration (15) n'est pas en contact avec un autre composant électronique (D) monté sur la carte imprimée (P), calculant un temps de déplacement nécessaire pour déplacer la buse d'aspiration (15) par rotation d'un bord de la table de déplacement vertical (63) à une position cible sur la table de déplacement vertical (63), calculant un temps de base en ajoutant un temps de retard de démarrage du mécanisme de déplacement vertical (51) au plus court du temps d'abaissement et du temps de déplacement, calculant une distance de déplacement du déplacement de la buse d'aspiration (15) par rotation pendant le temps de base, déterminant une position de retour à partir de la position cible sur la table de déplacement vertical (63) de la distance de déplacement en tant que position de départ pour le mécanisme de déplacement vertical (51), et lançant le mécanisme de déplacement vertical (51) lorsque le dispositif de commande (90) reconnaît que la buse d'aspiration (15) passe par la position de départ par rotation.

2. Dispositif de montage de composants électroniques selon la revendication 1, comprenant en outre une mémoire (92) mémorisant des données de taille du composant électronique (D), des données concernant la hauteur à laquelle la surface inférieure du composant électronique (D) n'est pas en contact avec un autre composant électronique (D) monté sur la carte imprimée (P), la hauteur de la buse d'aspiration (15) avant qu'elle ne commence à s'abaisser, et une vitesse d'abaissement et une vitesse de rotation de la buse d'aspiration (15).

3. Dispositif de montage de composants électroniques comportant une unité d'alimentation en composants (3) fournissant un composant électronique (D), une buse d'aspiration (15) prenant le composant électronique (D) fourni par l'unité d'alimentation en composants (3) par aspiration, une tête de montage (16) pourvue de la buse d'aspiration (15), un mécanisme de rotation (33) faisant tourner la tête de montage (16) autour d'un axe vertical et une table de déplacement vertical (63) déplaçant verticalement la tête de montage (16) par la mise en oeuvre d'un mécanisme de déplacement vertical (51), et montant le composant électronique (D) pris par aspiration par la buse d'aspiration (15) sur une carte imprimée (P) en déplaçant verticalement la buse d'aspiration (15), le dispositif de montage de composants électroniques comprenant :
un dispositif de commande calculant un temps d'abaissement nécessaire pour abaisser la buse d'aspiration (15) à une hauteur (H1) à laquelle la buse d'aspiration (15) n'est pas en contact avec l'unité d'alimentation en composants (3), calculant un temps de déplacement nécessaire pour déplacer la buse d'aspiration (15) par rotation d'un bord de la table de déplacement vertical à une position cible sur la table de déplacement vertical (63), calculant un temps de base en ajoutant un temps de retard de démarrage du mécanisme de déplacement vertical (51) au plus court du temps d'abaissement et du temps de déplacement, calculant une distance de déplacement du déplacement de la buse d'aspiration (15) par le mécanisme de rotation (33) pendant le temps de base, déterminant une position de retour à partir de la position cible sur la table de déplacement vertical (63) de la distance de déplacement en tant que position de départ pour le mécanisme de déplacement vertical (51), et lançant le mécanisme de déplacement vertical (51) lorsque le dispositif de commande reconnaît que la buse d'aspiration (15) passe par la position de départ par rotation.

4. Dispositif de montage de composants électroniques selon la revendication 3, comprenant en outre une mémoire (92) mémorisant des données de taille du composant électronique (D), des données concernant la hauteur à laquelle la buse d'aspiration (15) n'est pas en contact avec l'unité d'alimentation en composants (3), la hauteur de la buse d'aspiration (15), et une vitesse d'abaissement de la buse d'aspiration (15).

5. Dispositif de montage de composants électroniques selon la revendication 1 ou 3, dans lequel la position cible sur la table de déplacement vertical (63) est située au centre de la table de déplacement vertical (63).
